# EUROPEAN PATENT APPLICATION

(11) **EP 4 815 677 A1**
(43) Date of publication of application: **30.09.2026**
(21) Application number: 25189381.4
(22) Date of filing: 14.07.2025
(51) Int. Cl.: H10F 10/165, H10F 71/00, H10F 77/20

(54) **SOLAR CELL, MANUFACTURING METHOD THEREFOR, AND PHOTOVOLTAIC MODULE**

(30) Priority: 28.03.2025 CN 202510389521
(71) Applicant: Zhejiang Jinko Solar Co., Ltd., Haining, Zhejiang 314416 (CN)
(72) Inventor: ZHANG, Xinyu, Haining, 314416 (CN); LI, Huimin, Haining, 314416 (CN); XU, Menglei, Haining, 314416 (CN); YANG, Jie, Haining, 314416 (CN)
(74) Representative: Balder IP Law, S.L.

(57) **Abstract**

A solar cell includes a substrate having a first region, a second region, and a transition region located on a back surface thereof; a first tunneling layer on the first region; a first doped conductive layer on the first tunneling layer; a second tunneling layer on the second protrusion; a second doped conductive layer on the second tunneling layer; a third doped conductive layer including: a first part a sidewall of the first doped conductive layer, a second part on a sidewall of the transition region, and a third part extending from an end of the second part in a direction away from the first region towards the second region. The first doped conductive layer has doping ions of a first type, and the third doped conductive layer has doping ions of a second type different form the first type.

## Description

### TECHNICAL FIELD

Embodiments of the present disclosure relate to the technical field of photovoltaics, and in particular to a solar cell, a manufacturing method therefor and a photovoltaic module.

### BACKGROUND

Crystalline silicon solar cells have evolved from BSF and PERC to PERC+, and through continuous technological iteration and upgrading, the conversion efficiency of crystalline silicon solar cells is also continuously improving. Currently, the efficiency of mass-manufactured PERC+ cells has reached about 23.45%, which is close to its theoretical limit efficiency of 24.5%. The difficulty of further efficiency improvement in the future has increased, and the room for improvement is limited. Nowadays, TOPcon cells, HJT cells, back contact cells, etc. have become new development trends in crystalline silicon solar cells and are the frontier of international research and industrialization.

Among them, back contact cell refers to a crystalline silicon solar cell in which both the emitter region electrode and the base region electrode of the cell are located on the second surface of the cell. The back contact cell has no metal finger electrode on the first surface, which increases the absorption efficiency of light and greatly improves the short-circuit current. Moreover, the back contact cell adopts amorphous silicon or microcrystalline silicon and doped forms thereof to passivate the surface of the cell, which improves the open circuit voltage. The above factors effectively increase the conversion efficiency of the back contact cell, making it have good development prospects.

At present, back contact cells are plagued by hot spot phenomena, and there is an urgent need to propose a new cell manufacturing method to alleviate the hot spot phenomenon in the formed cells.

### SUMMARY

Embodiments of the present disclosure provide a solar cell, a manufacturing method therefor, and a photovoltaic module, which can at least alleviate the hot spot phenomenon.

According to one aspect of the present disclosure, some embodiments of the present disclosure provide a solar cell, including a substrate including a first surface and a second surface opposing the first surface, where the second surface has a first region and a second region arranged thereon, and a transition region between the first region and the second region, the transition region having a sidewall; a first tunneling layer on the first region; a first doped conductive layer on the first tunneling layer, the first doped conductive layer having a sidewall; a second tunneling layer on the second region; a second doped conductive layer, on the second tunneling layer; a third doped conductive layer having a first part on the sidewall of the first doped conductive layer, a second part on the sidewall of the transition region, and a third part extending from an end of the second part in a direction away from the first region toward the second region, wherein the first doped conductive layer has doping ions of a first type, and the third doped conductive layer has doping ions of a second type different form the first type; and a passivation layer over at least surfaces of the first doped conductive layer, the second doped conductive layer, and the third doped conductive layer, wherein the passivation layer has a first portion over a surface of the first part, and a second portion over a surface of the second part, and wherein the first portion has a first thickness, and the second portion has a second thickness less than the first thickness.

In some embodiments, a ratio of the first thickness to the second thickness ranges from 1 to 0.2.

In some embodiments, the first thickness ranges from 70 nm to 180 nm, and the second thickness ranges from 14 nm to 180 nm.

In some embodiments, an orthographic projection of the first part on the second surface of the substrate at least partially overlaps with an orthographic projection of the third part on the second surface of the substrate.

In some embodiments, a length of the first part in a direction from the first region towards the second region ranges from 0.2 µm to 3 µm.

In some embodiments, a ratio of a thickness of the first doped conductive layer to a thickness of the third doped conductive layer ranges from 0.5 to 2.

In some embodiments, the solar cell further includes a third tunneling layer, located between the first doped conductive layer and the third doped conductive layer, and between the third doped conductive layer and the substrate.

In some embodiments, the thickness of the passivation layer located on a sidewall of the first region gradually increases in a direction from the first region towards the transition region.

According to another aspect of the present disclosure, some embodiments of the present disclosure provide a manufacturing method for the solar cell, including providing a substrate including a first surface and a second surface opposing the first surface, where the second surface has a first region and a second region arranged thereon, and a transition region between the first region and the second region, the transition region having a sidewall; forming a first tunneling layer on the first region; forming a first doped conductive layer to cover a surface of the first tunneling layer, and forming a first glass layer to cover a surface of the first doped conductive layer, where the first glass layer protrudes from a sidewall of the first doped conductive layer; forming a second tunneling layer on the second region; forming a second doped conductive layer on the second tunneling layer; forming a third doped conductive layer, where a third doped conductive layer has a first part on the sidewall of the first doped conductive layer, a second part on the sidewall of the transition region, and a third part extending from an end of the second part in a direction away from the first region toward the second region, wherein the first doped conductive layer has doping ions of a first type, and the third doped conductive layer has doping ions of a second type different form the first type.

In some embodiments, forming the third doped conductive layer includes forming an initial second doped conductive layer, where the initial second doped conductive layer coves the surface of the second tunneling layer, and the initial second doped conductive layer covers a surface of the first glass layer, and the initial second doped conductive layer further covers a surface of the second region and a surface of the transition region; and etching the initial second doped conductive layer to remove the initial second doped conductive layer located on the surface of the first glass layer and partially remove the initial second doped conductive layer located on the surface of the transition region, where the remaining initial second doped conductive layer located on the second region is used as the second doped conductive layer, and the remaining initial second doped conductive layer located on a sidewall of the transition region and a sidewall of the first region is used as the third doped conductive layer.

In some embodiments, forming the initial second doped conductive layer further includes forming a second glass layer to cover a surface of the initial second doped conductive layer. In some embodiments, etching the initial second doped conductive layer includes performing a laser process, where the laser process irradiates the second glass layer located on the first region and a portion of the second glass layer located on the transition region; and performing an etching process to etch the second glass layer irradiated by the laser process and the initial second doped conductive layer to form the second doped conductive layer and the third doped conductive layer.

According to another aspect of the present disclosure, some embodiments of the present disclosure further provide a photovoltaic module which includes at least one cell string including multiple solar cells as described above, or multiple solar cells formed by the manufacturing method as described above; solder ribbons electrically connecting adjacent solar cells in series; an encapsulation film, configured for covering a surface of the at least one cell string; and a cover plate, configured for covering a surface of the encapsulation film away from the at least one cell string.

### BRIEF DESCRIPTION OF THE DRAWINGS

One or more embodiments are illustrated through the figures in the corresponding drawings. These exemplary illustrations do not constitute limitations on the embodiments unless otherwise stated. The figures in the accompanying drawings do not constitute a scale limitation. In order to illustrate the technical solutions in the embodiments of the present disclosure or in the conventional technology more clearly, the drawings used in the following description of the embodiments are briefly described below. It is apparent that the drawings in the following description show only some embodiments of the present disclosure, and other drawings may be obtained by those of ordinary skill in the art based on these drawings without any creative efforts.
FIG. 1 shows a structural view of a solar cell provided in an embodiment of the present disclosure;
FIG. 2 shows an enlarged view of a third doped conductive layer provided in an embodiment of the present disclosure;
FIGS. 3 to 6 show structural views corresponding to the steps of the manufacturing method for the solar cell provided in an embodiment of the present disclosure;
FIG. 7 shows a schematic structural view of a photovoltaic module provided in an embodiment of the present disclosure; and
FIG. 8 shows a cross-sectional view of the photovoltaic module provided in an embodiment of the present disclosure.

### DETAILED DESCRIPTION OF THE EMBODIMENTS

From the background technology, it is known that currently, when a solar cell is locally shaded or abnormalities occur in the cell, a hot spot phenomenon is prone to occur in the solar cell. The hot spot phenomenon refers to a phenomenon where certain regions in the cell or module have a significantly higher temperature than other parts due to local overheating. This phenomenon is generally caused by uneven current distribution or high local resistance, which may seriously impair the performance and lifespan of the solar cell. Therefore, there is an urgent need to alleviate the hot spot phenomenon in solar cells.

Embodiments of the present disclosure provide a solar cell, a manufacturing method therefor, and a photovoltaic module. In the solar cell according to the present disclosure, a third doped conductive layer is provided to be electrically connected to the first doped conductive layer, thereby forming a leakage path between the third doped conductive layer and the first doped conductive layer. In this way, when the hot spot phenomenon occurs, the leakage path can shunt the current to alleviate the hot spot phenomenon of the solar cell. The first part of the third doped conductive layer is used for constructing the leakage path, and the second and third parts can provide a good passivation effect on the substrate, thereby further improving the performance of the solar cell. On the other hand, the first thickness is greater than the second thickness. The first part of the third doped conductive layer is used for constructing the leakage path. Providing a thicker passivation layer on the first part can prevent excessive leakage, and balance hot spot protection and electrical performance. Providing a thinner passivation layer on the surface of the second part can reduce interface recombination at the sidewall of the first region and improve the filling factor of the solar cell.

In the description of the embodiments of the present disclosure, technical terms such as "first", "second", etc., are merely used for distinguishing different objects and should not be construed as indicating or implying relative importance or as implicitly specifying the number, specific order, or priority of the technical features referred to. In the description of the embodiments of the present disclosure, the term "plurality of/plural/multiple" refers to two or more, unless otherwise explicitly specified.

The mention of "embodiment" in this paper means that the specific features, structures, or characteristics described in conjunction with the embodiments may be included in at least one embodiment of the present disclosure. The appearance of this phrase at various locations in the specification does not necessarily refer to the same embodiment, nor is it an independent or alternative embodiment that is exclusive with other embodiments. Those skilled in the art can understand explicitly and implicitly that the embodiments described in this paper can be combined with other embodiments.

In the description of the embodiments of the present disclosure, the term "and/or" merely describes the associative relationship between associated objects, indicating that there can be three types of relationships. For example, A and/or B can represent three possible situations sole existence of A, existence of both A and B, and sole existence of B. Additionally, the character "/" in this paper generally indicates that the associated objects with this character are in an "or" relationship.

In the description of the embodiments of the present disclosure, the term "plurality of/plural/multiple" refers to two or more (including two). Similarly, "plurality of/plural/multiple groups" refers to two or more groups (including two groups), and "plurality of/plural/multiple pieces" refers to two or more pieces (including two pieces).

In the description of the embodiments of the present disclosure, the technical terms "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc., indicate the orientation or positional relationship based on the orientation or positional relationship shown in the accompanying drawings. This is solely for the purpose of facilitating the description of the embodiments of the present disclosure and simplifying the description, and in no way indicate or imply that the devices or elements referred to must have a specific orientation, be constructed or operated in a specific orientation. Therefore, these terms should not be construed as a limitation on the embodiments of the present disclosure.

In the description of the embodiments of the present disclosure, unless otherwise explicitly specified and defined, the technical terms such as "installation", "connection", "fixation", etc. should be understood in a broad sense. For example, "connection" may refer to fixed connection, detachable connection, or integral connection; mechanical connection or electrical connection; direct connection, or indirect connection through an intermediary. It may further refer to the internal connectivity between two components or the interaction between two components. For those of ordinary skill in the art, the specific meanings of the above terms in embodiments of the present disclosure should be understood according to the specific circumstances.

In the drawings corresponding to the embodiments of the present disclosure, the thickness and area of the layers have been exaggerated for better understanding and ease of description. When a component (such as a layer, film, region, or substrate) is described as being on another component or on the surface of another component, the component may be "directly" located on the surface of the another component, or a third component may exist between the two components. On the contrary, when one component is described as being at the surface of another component, or when it recites that one component's surface forms or is provided with another component, it indicates that there is no third component between the two components. In addition, when it recites that a component is "roughly" formed on another component, it means that this component is not formed on the entire surface (or first surface) of the another component, nor is it formed on a portion of the edge of the entire surface.

In the description of the embodiments of the present disclosure, when it recites that one component "includes" another component, it does not exclude other components and other components may also be further included unless otherwise stated. In addition, when a component such as a layer, film, region, or plate is referred to as being "on/located on" another component, it can either be "directly on" the another component (i.e., located on the surface of the another component without any other components in between), or yet another component may exist between them. In addition, when a component such as a layer, film, region, or plate is referred to as being "directly located on" another component, or when a component such as a layer, film, region, or plate is referred to as being located on the surface of another component, it indicates that no other components are located between them.

The terms used in the description of various embodiments mentioned in this paper are solely for the purpose of describing specific embodiments and are not intended to be restrictive. The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise.

The following provides a detailed description of the various embodiments of the present disclosure in conjunction with the accompanying drawings. However, those of ordinary skill in the art may understand that in various embodiments of the present disclosure, many technical details have been presented to facilitate a better understanding of the present disclosure by the reader. However, even without these technical details and the various variations and modifications based on the following embodiments, the technical solution claimed in the present disclosure can still be achieved.

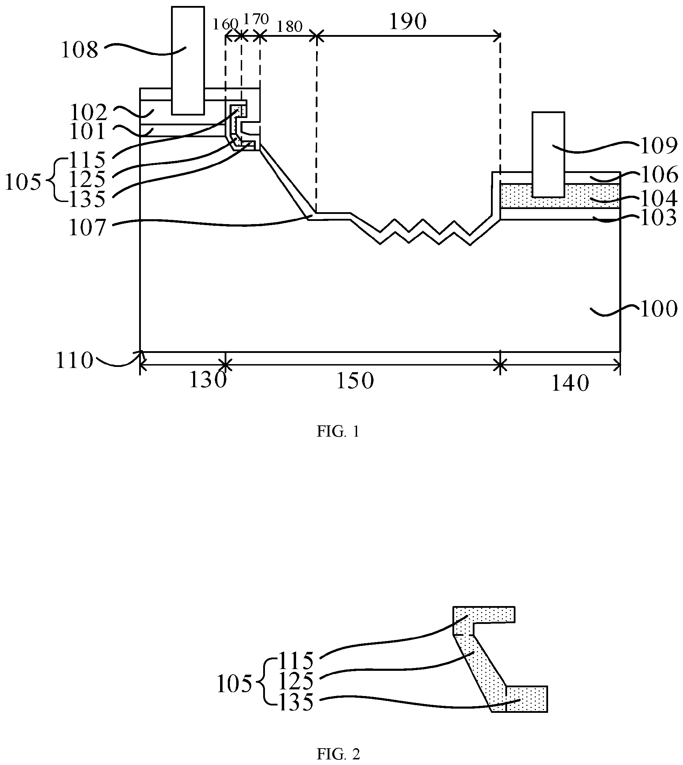

Referring to FIG. 1 and FIG. 2, FIG. 1 shows a structural view of a solar cell provided in an embodiment of the present disclosure, and FIG. 2 shows an enlarged view of a third doped conductive layer provided in an embodiment of the present disclosure.

In some embodiments, the solar cell includes a substrate 100, including a first surface 110 and a second surface 120 opposing the first surface 110, where the second surface 120 has a first region 130 and a second region 140 arranged thereon, and a transition region 150 between the first region 130 and the second region 140.

The solar cell further includes a first tunneling layer 101 on the first region 130.

The solar cell further includes a first doped conductive layer 102 on the first tunneling layer 101. The first doped conductive layer 102 has a sidewall.

The solar cell further includes a second tunneling layer 103on the second region 140.

The solar cell further includes a second doped conductive layer 104, on the second tunneling layer 103.

The solar cell further includes a third doped conductive layer 105 having a first part 115 on the sidewall of the first doped conductive layer 102, a second part 125 on the sidewall of the transition region 150, and a third part 135 extending from an end of the second part 125 in a direction away from the first region 130 toward the second region 140 , wherein the first doped conductive layer 102 has doping ions of a first type, and the third doped conductive layer 105 has doping ions of a second type different form the first type.

The solar cell further includes a passivation layer 106 over at least surfaces of the first doped conductive layer 102, the second doped conductive layer 104, and the third doped conductive layer 105, where a thickness of the passivation layer 106 on the first part 115 is greater than a thickness of the passivation layer 106 on the second part 125.

According to the embodiments of the present disclosure, on the one hand, the third doped conductive layer 105 is provided to be electrically connected to the first doped conductive layer 102, thereby forming a leakage path between the third doped conductive layer 105 and the first doped conductive layer 102. In this way, when the hot spot phenomenon occurs, the leakage path can shunt the current to alleviate the hot spot phenomenon of the solar cell. The first part 115 of the third doped conductive layer 105 is used for constructing the leakage path, and the second and third parts 125 and 135 can provide a good passivation effect on the substrate 100, thereby further improving the performance of the solar cell. On the other hand, the first thickness is greater than the second thickness. The first part 115 of the third doped conductive layer 105 is used for constructing the leakage path. Providing a thicker passivation layer 106 on the first part 115 can prevent excessive leakage, and balance hot spot protection and electrical performance. Providing a thinner passivation layer 106 on the surface of the second part 125 can reduce interface recombination at the sidewall of the first region 130 and improve the filling factor of the solar cell.

The substrate 100 is configured to receive incident light and generate photogenerated carriers. In some embodiments, the substrate 100 may be a semiconductor substrate, such as silicon, germanium, germanium silicon, or silicon on insulator.

In some embodiments, the material of the substrate 100 may be a material of an element semiconductor. Specifically, the material of an element semiconductor consists of a single element, such as silicon or germanium. The material of an element semiconductor may exist in single crystal, polycrystalline, amorphous, or microcrystalline states (which has both the single crystal state and the amorphous state). For instance, silicon may be at least one of single crystal silicon, polycrystalline silicon, amorphous silicon, or microcrystalline silicon. If the material of the substrate 100 is silicon, the material of the substrate 100 may include at least one of single crystal silicon, polycrystalline silicon, amorphous silicon, or microcrystalline silicon.

The substrate 100 may be an N-type semiconductor substrate or a P-type semiconductor substrate. The N-type semiconductor substrate is doped with N-type doping elements, which may be any one of the group 5 elements such as phosphorus (P), bismuth (Bi), antimony (Sb), or arsenic (As). The P-type semiconductor substrate is doped with a P-type element, which may be any one of the group 3 elements such as boron (B), aluminum (Al), gallium (Ga), or indium (In).

The solar cell is a monofacial cell, with the first surface 110 of the substrate 100 serving as a light-receiving surface to receive incident light, and the second surface 120 of the substrate 100 serving as a back-light surface.

The first region 130 corresponds to one of the N and P regions in the cell, and the second region 140 corresponds to the other of the N and P regions in the cell. The transition region 150 serves as the separation between the N and P regions.

In some embodiments, the transition region 150 includes a first transition region 160, a flat region 170, a second transition region 180, and a textured region 190. The first transition region 160 abuts the first region 130, and the second part of the third doped conductive layer 105 may be located on the surface of the first transition region 160. The flat region 170 abuts the first transition region 160, and the third part 135 of the third doped conductive layer 105 may be located in the flat region 170. The second transition region 180 connects the flat region 170 and the textured region 190. The textured region 190 has a pyramid shaped morphology.

The flat region 170 can support part of the third doped conductive layer 105. The second transition region 180 is used for forming a transition bridge between the flat region 170 and the textured region 190. The morphological difference between the flat region 170 and the textured region 190 may lead to the concentration of mechanical stress. The second transition region 180 can also disperse stress through gradually changing surface morphology, avoiding cracks or damage at the junction of the cell due to stress concentration. The textured region 190 is used for increasing the light reflection ability in the transition region 150, which can reflect the light incident on the second surface 120 back into the substrate 100, thereby improving the light absorption ability of the solar cell.

In some embodiments, the material of the first tunneling layer 101 may be silicon oxide, silicon nitride, or silicon oxynitride. The first tunneling layer 101 is used for passivating the substrate 100 on one hand, and on the other hand, it does not affect the transport of carriers, and can damp the interfacial tension between the substrate 100 and the first doped conductive layer 102, thereby reducing losses in carrier transport.

The first doped conductive layer 102 may be doped polycrystalline silicon, which has good conductivity and can effectively transport carriers. The doped polycrystalline silicon has good ohmic contact with the subsequently formed first electrode 108, which can reduce the contact resistance between the first electrode 108 and the first doped conductive layer 102.

The material of the second tunneling layer 103 may be the same as that of the first tunneling layer 101, such as silicon oxide, silicon nitride, or silicon oxynitride, which can reduce the number of types of materials in the solar cell, reduce the number of processes required to form the solar cell, and reduce the difficulty of forming the solar cell. The material of the second tunneling layer 103 may alternatively be intrinsic amorphous silicon. Intrinsic amorphous silicon has excellent surface passivation properties, which can significantly reduce carrier recombination on the second surface. Moreover, the interface state density can be reduced by passivating dangling bonds with hydrogen atoms inside intrinsic amorphous silicon, thereby reducing recombination and improving open circuit voltage and fill factor.

The material of the second doped conductive layer 104 may be the same as that of the first doped conductive layer 102, which can reduce the number of types of materials in the solar cell, reduce the number of processes required to form the solar cell, and reduce the difficulty of forming the solar cell. The material of the second doped conductive layer 104 may alternatively be doped amorphous silicon.

When the second tunneling layer 103 is made of intrinsic amorphous silicon, the material of the second doped conductive layer 104 is selected to be doped amorphous silicon. When the second tunneling layer 103 is made of silicon oxide, silicon nitride, or silicon oxynitride, the material of the second doped conductive layer 104 is selected to be doped polycrystalline silicon.

In some embodiments, the solar cell further includes a third tunneling layer 107, located between the first doped conductive layer 102 and the third doped conductive layer 105, and between the third doped conductive layer 105 and the substrate 100. The third tunneling layer 107 plays a passivation role without affecting the transport of carriers, which can improve the performance of the solar cell.

The material of the third tunneling layer 107 may be the same as that of the second tunneling layer 103, so that the third tunneling layer 107 and the second tunneling layer 103 can be formed in the same process step, which can reduce the process steps for forming the solar cell.

The material of the third doped conductive layer 105 is the same as that of the second doped conductive layer 104. Similarly, the third doped conductive layer 105 and the second doped conductive layer 104 can be formed in the same process step, and then be separated by other process steps.

In some embodiments, a ratio of the thickness of the first doped conductive layer 102 to the thickness of the third doped conductive layer 105 ranges from 0.5 to 2, for example, 1, 1.1, 1.2, 1.3, 1.4, 1.5, or 1.8. The first doped conductive layer 102 is configured to collect photogenerated carriers. The thicker the first doped conductive layer 102, the higher the collection efficiency of photogenerated carriers in the first doped conductive layer 102. The third doped conductive layer 105 is mainly provided for current leakage, and the thicker the third doped conductive layer 105, the stronger the leakage ability and the higher the effect of improving the hot spot phenomenon. If the ratio of the thickness of the first doped conductive layer 102 to the thickness of the third doped conductive layer 105 is less than 0.5, the leakage effect of the third doped conductive layer 105 may be too strong, which may lead to a decrease in the photoelectric conversion efficiency of the solar cell. If the ratio of the thickness of the first doped conductive layer 102 to the thickness of the third doped conductive layer 105 is greater than 2, it means that the third doped conductive layer 105 is too thin, which will lead to weak leakage ability and poor improvement of the leakage effect of the solar cell.

In some embodiments, the ratio of the thickness of the first doped conductive layer 102 to the thickness of the third doped conductive layer 105 ranges from 1 to 1.5. In the manufacturing process of the solar cell, the second doped conductive layer 104 and the third doped conductive layer 105 may be formed in the same process step, thereby reducing the number of process steps in the manufacturing method of solar cells and lowering costs. Based on this, the ratio of the thickness of the first doped conductive layer 102 to the thickness of the third doped conductive layer 105 preferably ranges from 1 to 1.5, where account is also taken of the function of the second doped conductive layer 104 to collect photogenerated carriers.

In some embodiments, the orthographic projection of the first part 115 on the surface of the substrate 100 partially overlaps with the orthographic projection of the third part 135 on the surface of the substrate 100. In other words, the first part 115 partially shades the third part 135. The overlapping projections of the first part 115 and the third part 135 indicate that the third doped conductive layer 105 extends from the first region 130 to the transition region 150, and the third doped conductive layer 105 is continuous between the first region 130 and the transition region 150. This continuity ensures that the current is evenly distributed between the first region 130 and the transition region 150, avoiding local current concentration.

It can be understood that the transition region 150 serves as an isolated region between the first region 130 and the second region 140, thereby preventing short circuits between the first region 130 and the second region 140. However, if the transition region 150 is completely insulated, charge accumulation or local electric field concentration may occur due to potential difference, leading to current leakage or hot spots. Therefore, a third doped conductive layer 105 is provided to extend from the first region 130 to the transition region 150 to form a lightly conductive leakage path between the first region 130 and the transition region 150. This leakage path has high resistance, which does not significantly shunt the main current but can provide a bypass.

In some embodiments, in the direction from the first region 130 towards the second region 140, the length of the first part 115 ranges from 0.2 µm to 3 µm, for example, 0.3 µm, 0.5 µm, 0.7 µm, 0.9 µm, 1 µm, 1.5 µm, 2 µm, 2.5 µm, or 2.8 µm, etc. It can be understood that if the length of the first part 115 is too large, it will affect the length of the formed third part 135 during the formation of the third doped conductive layer 105. Therefore, an excessively long first part 115 will result in an excessively long third doped conductive layer 105, which may affect the photoelectric conversion efficiency of the solar cell. Conversely, if the length of the first portion 115 is too short, it may impair the leakage capability of the first part 115 itself, potentially leading to poor improvement in the hot spot phenomenon of the solar cell.

In some embodiments, the length of the first part 115 is less than 1 µm, which can ensure that the third doped conductive layer 105 has a certain leakage capability while preventing the third doped conductive layer 105 from affecting the collection of carriers within the solar cell.

In some embodiments, a ratio of the first thickness to the second thickness ranges from 1 to 0.2.

If the ratio of the first thickness to the second thickness is less than 0.2, the passivation layer covering the surface of the second part is too thick, which may increase the diffusion path of carriers and increase the probability of recombination. If the ratio of the first thickness to the second thickness is greater than 1, the passivation layer covering the surface of the first part is too thin, which may cause local breakdown in the first part and reduce the reliability of the solar cell.

In some embodiments, the first thickness ranges from 70 nm to 180 nm, for example, 80 nm, 90 nm, 100 nm, 110 nm, 120 nm, 130 nm, 140 nm, 150 nm, 160 nm, or 170 nm. The second thickness ranges from 14 nm to 180 nm, such as 20 nm, 30 nm, 40 nm, 50 nm, 70 nm, 100 nm, 150 nm, or 170 nm, etc.

It can be understood that if the thickness of the passivation layer 106 covering the surface of the first part 115 is less than 70 nm, it may not effectively suppress surface recombination. If the first thickness is greater than 180 nm, the passivation layer is too thick, which may affect the leakage ability of the first part 115 and lead to a decrease in its leakage ability. If the second thickness is less than 14 nm, it will lead to a decrease in the passivation ability of the passivation layer 106, which may increase carrier recombination. If the second thickness is greater than 180 nm, it may suppress the leakage function of the sidewall and destroy its synergy with the first part 115.

In some embodiments, the second thickness gradually increases in the direction from the first region 130 towards the transition region 150. In other words, the passivation layer 106 gets thicker while approaching the transition region 150. The transition region 150 is generally a high resistance region that is prone to charge accumulation, causing local electric field distortion. Configuring the passivation layer 106 to be thicker while approaching the transition region 150 can suppress leakage at the edge of the transition region 150. Moreover, in the manufacturing process of the solar cell, the passivation layer closer to the sidewall of the transition region 150 is more prone to damage. Configuring the passivation layer 106 to be thicker while approaching the transition region 150 helps carriers flow more smoothly from the first region 130 to the electrode, rather than being trapped by trap states in the sidewall.

In some embodiments, the solar cell further includes a first electrode 108 and a second electrode 109. The first electrode 108 is electrically connected to the first doped conductive layer 102, and the second electrode 109 is electrically connected to the second doped conductive layer 104.

According to the embodiments of the present disclosure, on the one hand, the third doped conductive layer 105 is provided to be electrically connected to the first doped conductive layer 102, thereby forming a leakage path between the third doped conductive layer 105 and the first doped conductive layer 102. In this way, when the hot spot phenomenon occurs, the leakage path can shunt the current to alleviate the hot spot phenomenon of the solar cell. The first part 115 of the third doped conductive layer 105 is used for constructing the leakage path, and the second and third parts 125 and 135 can provide a good passivation effect on the substrate 100, thereby further improving the performance of the solar cell. On the other hand, the first thickness is greater than the second thickness. The first part 115 of the third doped conductive layer 105 is used for constructing the leakage path. Providing a thicker passivation layer 106 on the first part 115 can prevent excessive leakage, and balance hot spot protection and electrical performance. Providing a thinner passivation layer 106 on the surface of the second part 125 can reduce interface recombination at the sidewall of the first region 130 and improve the filling factor of the solar cell.

Another embodiment of the present disclosure further provides a method for manufacturing a solar cell, which is suitable for forming some or all of the solar cells in the above embodiments. The following will explain the method for manufacturing the solar cell provided in another embodiment of the present disclosure in conjunction with the accompanying drawings. It should be noted that for the same or corresponding parts in the foregoing embodiments, reference may be made to the corresponding descriptions in the foregoing embodiments, and they will not be repeated hereinafter.

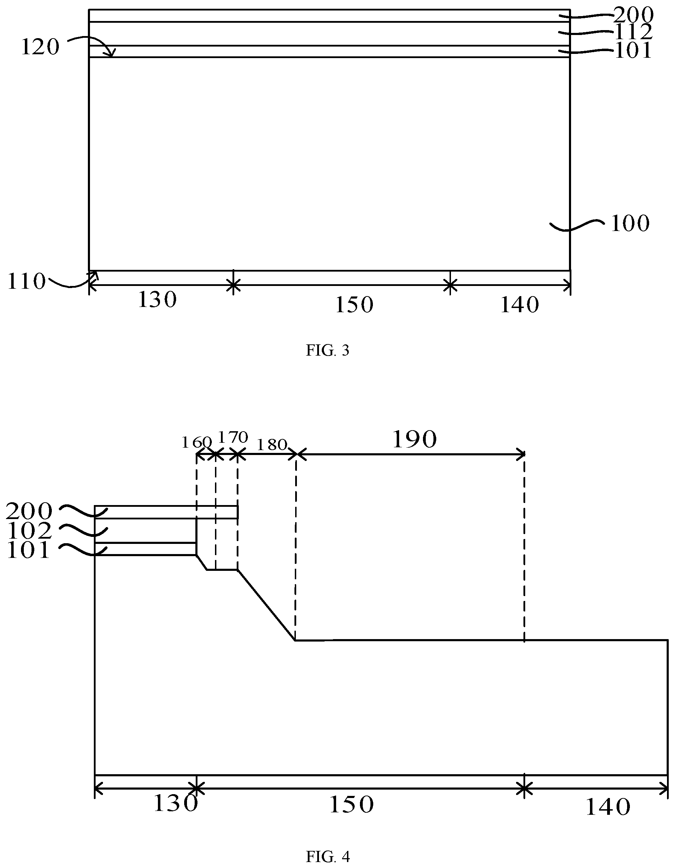

With reference to FIGS. 3 to 6, FIGS. 3 to 6 show structural views corresponding to the steps of the manufacturing method for the solar cell provided in another embodiment of the present disclosure.

In some embodiments, the manufacturing method includes providing a substrate 100 including a first surface 110 and a second surface 120 opposing the first surface 110, where the second surface 120 has a first region 130 and a second region 140 arranged thereon, and a transition region 150 between the first region 130 and the second region 140.

The manufacturing method further includes forming a first tunneling layer 101 on the first region 130.

The manufacturing method further includes forming a first doped conductive layer 102 to cover a surface of the first tunneling layer 101, and forming a first glass layer 200 to cover a surface of the first doped conductive layer 102, where the first glass layer 200 protrudes from a sidewall of the first doped conductive layer 102.

The manufacturing method further includes forming a second tunneling layer 103 on the second region 104.

The manufacturing method further includes forming a second doped conductive layer 104 on the second tunneling layer 103.

The manufacturing method further includes forming a third doped conductive layer 105. The third doped conductive layer 105 has a first part 115 on the sidewall of the first doped conductive layer 102, a second part 125 on the sidewall of the transition region 150, and a third part 135 extending from an end of the second part 125 in a direction away from the first region 130 toward the second region 140. The first doped conductive layer 102 has doping ions of a first type, and the third doped conductive layer 105 has doping ions of a second type different form the first type.

The manufacturing method further includes removing the first glass layer 200.

The manufacturing method further includes forming a passivation layer 106 over at least surfaces of the first doped conductive layer 102, the second doped conductive layer 104, and the third doped conductive layer 105, where a thickness of the passivation layer 106 on the first part 115 is greater than a thickness of the passivation layer 106 on the second part 125.

A leakage path is established by means of the third doped conductive layer 105, so that when the hot spot phenomenon occurs, the leakage path can shunt the current to alleviate the hot spot phenomenon of the solar cell. Moreover, the second part 125 and the third part 135 of the third doped conductive layer 105 can provide a good passivation effect on the substrate 100, thereby further improving the performance of the solar cell. On the other hand, a passivation layer 106 is further provided. Configuring a thinner passivation layer 106 on the surface of the second part 125 can reduce interface recombination at the sidewall of the first region 130 and improve the filling factor of the solar cell.

Referring to FIG. 3 and FIG. 4, a first tunneling layer 101 and a first doped conductive layer 102 are formed.

Referring to FIG. 3, a first tunneling layer 101 and an initial first doped conductive layer 112 are formed. The first tunneling layer 101 covers the second surface 120, and the initial first doped conductive layer 112 covers the surface of the first tunneling layer 101.

In some embodiments, forming the initial first doped conductive layer 112 includes forming a polycrystalline silicon layer by deposition, and then converting the polycrystalline silicon layer into the initial first doped conductive layer 112 through diffusion process, where during the process of converting the polycrystalline silicon layer into the initial first doped conductive layer 112, a first glass layer 200 is also formed.

Referring to FIG. 4, a first doped conductive layer 102 is formed.

In some embodiments, forming the first doped conductive layer 102 includes performing a laser process, where the laser process irradiates the surface of the first glass layer 200; and performing a wet etching process, where since part of the first glass layer 200 undergoes the laser process, this part of the first glass layer 200 is modified and then removed during the wet etching process. Further, parts of the initial first doped conductive layer 112, the first tunneling layer 101, and even the substrate 100 are etched, thereby forming the first region 130, transition region 150, and second region 140 with different heights.

It can be understood that during the wet etching process, the etching process not only proceeds vertically but also horizontally. Therefore, after the wet etching process, part of the first glass layer 200 protrudes from the sidewall of the first region 130.

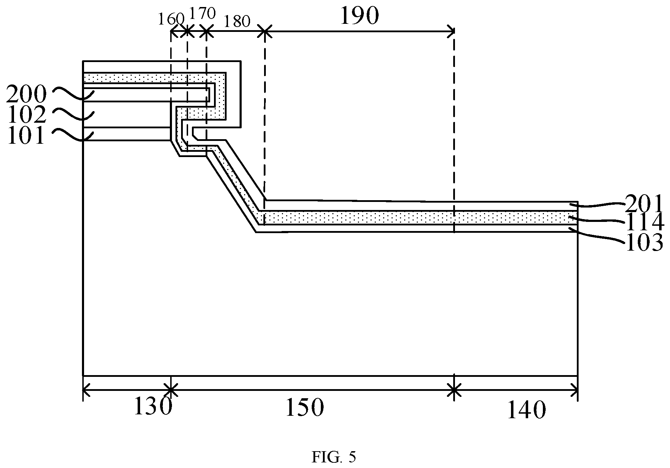

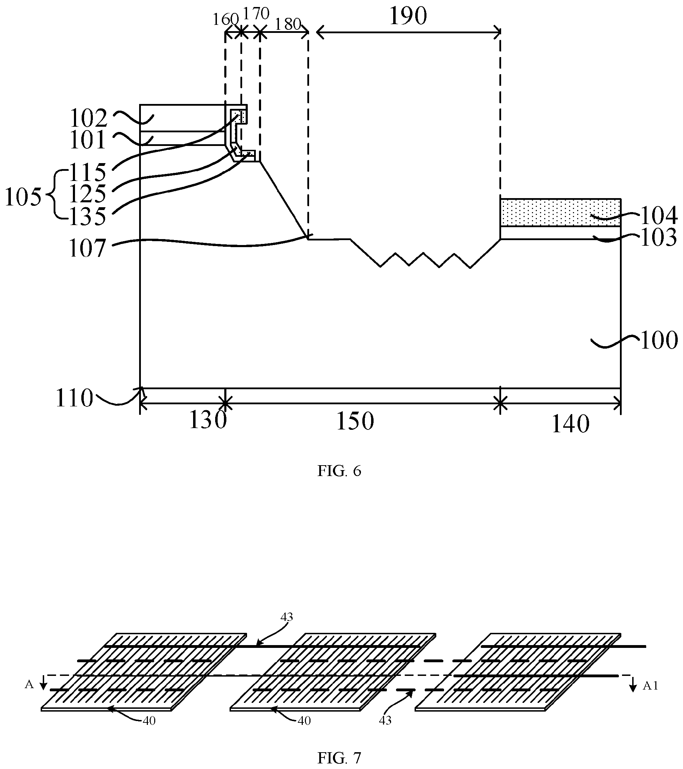

Referring to FIG. 5 and FIG. 6, a second tunneling layer, a second doped conductive layer and a third doped conductive layer are formed.

In some embodiments, forming the third doped conductive layer 105 includes forming an initial second doped conductive layer 114, where the initial second doped conductive layer 114 coves the surface of the second tunneling layer 103, and the initial second doped conductive layer 114 covers a surface of the first glass layer 200, and the initial second doped conductive layer 114 further covers a surface of the second region 140 and a surface of the transition region 150; and etching the initial second doped conductive layer 114 to remove the initial second doped conductive layer 114 located on the surface of the first glass layer 200 and partially remove the initial second doped conductive layer 114 located on the surface of the transition region 150, where the remaining initial second doped conductive layer 114 located on the second region 140 is used as the second doped conductive layer 104, and the remaining initial second doped conductive layer 114 located on a sidewall of the transition region 150 and a sidewall of the first region 130 is used as the third doped conductive layer 105. Forming the second doped conductive layer 104 and the third doped conductive layer 105 in the same process step can reduce the number of process steps in the manufacturing method of the solar cell and lower costs.

Referring to FIG. 5, a second tunneling layer and an initial second doped conductive layer are formed.

In some embodiments, the second tunneling layer 103 can be formed by full-area deposition. The second tunneling layer 103 covers the exposed surface of the first glass layer 200, also covers the sidewalls of the first tunneling layer 101 and the first doped conductive layer 102, and additionally covers the exposed surface of the substrate 100.

The initial second doped conductive layer 114 is then formed to cover a surface of the second tunneling layer 103.

In some embodiments, forming the initial second doped conductive layer 114 includes forming another polycrystalline silicon layer by deposition, and then converting the polycrystalline silicon layer into the initial second doped conductive layer 114 through diffusion process, where during the process of converting the polycrystalline silicon layer into the initial second doped conductive layer 114, a second glass layer 201 is also formed.

Referring to FIG. 6, a second doped conductive layer and a third doped conductive layer are formed.

In some embodiments, forming the initial second doped conductive layer 114 includes performing a laser process, where the laser process irradiates the second glass layer 201 located on the first region 130 and a portion of the second glass layer 201 located on the transition region 150; and performing an etching process to etch the second glass layer 201 irradiated by the laser process and the initial second doped conductive layer 114 to form the second doped conductive layer 104 and the third doped conductive layer 105. The second glass layer 201 is modified using a laser process, thereby completing the mold opening of the second glass layer 201 to facilitate the subsequent etching process.

In some embodiments, after forming the second doped conductive layer 104 and the third doped conductive layer 105, the method further includes removing the first glass layer 200 and the second glass layer 201, where during the removal process of the first glass layer 200 and the second glass layer 201, a second transition region 180 and a textured region 190 are formed in the gap region.

Referring to FIG. 1, a passivation layer 106, a first electrode 108, and a second electrode 109 are formed.

The passivation layer 106 can be directly formed by full-area deposition. It can be understood that since the first part 115 of the third doped conductive layer 105 is located on the sidewall of the first doped conductive layer 102, the sidewall of the first region 130 located below the first part 115 is shielded during the formation of the passivation layer 106, as a result of which the passivation layer 106 gets thinner as it approaches the first part 115.

In some embodiments, when forming the first region 130 and the second region 140 with different heights, due to the crystal orientation of the substrate 100, the first region 130 formed is trapezoidal. Thus, during the formation of the passivation layer 106, the closer it is to the third doped conductive layer 105, the smaller the formation space becomes, which affects the formation speed of the passivation layer 106. As a result, in the direction from the first region 130 toward the transition region 150, the thickness of the passivation layer 106 on the sidewall of the first region 130 gradually increases.

In some embodiments, the first electrode 108 and the second electrode 109 can be formed by screen printing. The first electrode 108 is electrically connected to the first doped conductive layer 102, and the second electrode 109 is electrically connected to the second doped conductive layer 104.

Another embodiment of the present disclosure further provides a photovoltaic module, which may include solar cells as described in some or all of the above embodiments, or solar cells formed by the manufacturing method as described in some or all of the above embodiments. It should be noted that, for parts that are the same as or corresponding to those in the above embodiments, reference may be made to the above embodiments, which will not be repeated hereinafter.

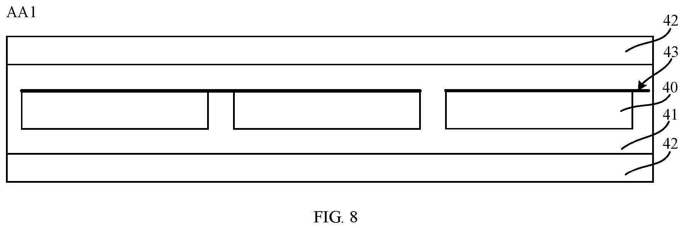

Referring to FIG. 7 and FIG. 8, FIG. 7 is a partial perspective view of a photovoltaic module provided in another embodiment of the present disclosure, and FIG. 8 is a partial cross-sectional view of FIG. 7 taken along the first cross-section AA1 in FIG. 7.

In some embodiments, the photovoltaic module includes at least one cell string including multiple solar cells 40 as described in some or all of the above embodiments, or solar cells formed by the manufacturing method as described above; and solder ribbons 43 electrically connecting adjacent solar cells 40 in series.

The photovoltaic module further includes an encapsulation film 41, configured for covering a surface of the at least one cell string.

The photovoltaic module further includes a cover plate 42, configured for covering a surface of the encapsulation film 41 away from the at least one cell string.

In some embodiments, the encapsulation adhesive film 41 includes a first encapsulation layer and a second encapsulation layer. The first encapsulation layer covers one of the first or second surfaces of the solar cell, and the second encapsulation layer covers the other of the front or second surfaces of the solar cell. Specifically, at least one of the first encapsulation layer and the second encapsulation layer may be an organic encapsulation film such as polyvinyl butyral (PVB) film, ethylene-vinyl acetate copolymer (EVA) film, polyethylene octene elastomer (POE) film, or polyethylene terephthalate (PET) film. Alternatively, at least one of the first encapsulation layer and the second encapsulation layer may be an EP film, EPE film, or PVP film. The EP film refers to a co-extruded film composed of stacked EVA film and POE film; the EPE film refers to a co-extruded film formed by sequentially stacked EVA film, POE film, and EVA film; and the PVP film refers to a co-extruded film formed by sequentially stacked POE film, EVA film, and POE film. The method of preparing the co-extruded film may involve, during the film processing, sequentially extruding one or more raw materials onto another pre-made film, or bonding different types of pre-made films to each other.

Under some cases, the first encapsulation layer and the second encapsulation layer have a boundary before lamination. After the lamination process, the boundary between the first encapsulation layer and the second encapsulation layer of the photovoltaic module no longer exists, as the first encapsulation layer and the second encapsulation layer have become an integral encapsulation layer 41 .

In some embodiments, the cover plate 42 may be a glass cover plate, a plastic cover plate, or any other cover plate with a light-transmitting function. Specifically, the surface of the cover plate 42 facing the encapsulation film 41 may be a concave-convex surface or a textured surface containing multiple protruding structures, so as to increase the utilization rate of incident light. The cover plate 42 includes a first cover plate and a second cover plate. The first cover plate opposes the first encapsulation layer, and the second cover plate opposes the second encapsulation layer.

Those of ordinary skill in the art can understand that the aforementioned embodiments are specific examples for implementing the present disclosure. In practical applications, various modifications can be made to them in form and detail without deviating from the scope of the present disclosure. A person skilled in the art may make various alterations and modifications without departing from the scope of the present disclosure, and thus the scope of protection of the present disclosure should be determined by the scope of the appended claims.

## Claims

1. A solar cell, comprising:
a substrate (100) including a first surface (110) and a second surface (120) opposing the first surface, wherein the back surface has a first region (130) and a second region (140) arranged thereon, and a transition region (150) between the first region (130) and the second region (140), the transition region (150) having a sidewall;
a first tunneling layer (101) on the first region (130);
a first doped conductive layer (102) on the first tunneling layer (101), the first doped conductive layer (102) having a sidewall;
a second tunneling layer (103) on the second region (140);
a second doped conductive layer (104) on the second tunneling layer (103);
a third doped conductive layer (105) having a first part (115) on the sidewall of the first doped conductive layer (102), a second part (125) on the sidewall of the transition region (150), and a third part (135) extending from an end of the second part (125) in a direction away from the first region (130) toward the second region (140), wherein the first doped conductive layer (102) has doping ions of a first type, and the third doped conductive layer (105) has doping ions of a second type different form the first type; and
a passivation layer (106) over at least surfaces of the first doped conductive layer (102), the second doped conductive layer (104), and the third doped conductive layer (105), wherein the passivation layer (106) has a first portion over a surface of the first part (115), and a second portion over a surface of the second part (125), and wherein the first portion has a first thickness, and the second portion has a second thickness less than the first thickness.

2. The solar cell according to claim 1, wherein a ratio of the first thickness to the second thickness ranges from 1 to 0.2.

3. The solar cell according to claim 1 or 2, wherein the first thickness ranges from 70 nm to 180 nm, and the second thickness ranges from 14 nm to 180 nm.

4. The solar cell according to claim 1, wherein an orthographic projection of the first part on the second surface of the substrate at least partially overlaps with an orthographic projection of the third part on the second surface of the substrate.

5. The solar cell according to claim 1 or 4, wherein a length of the first part in a direction from the first region towards the second region ranges from 0.2 µm to 3 µm.

6. The solar cell according to claim 1, wherein a ratio of a thickness of the first doped conductive layer to a thickness of the third doped conductive layer ranges from 0.5 to 2.

7. The solar cell according to claim 1, further comprising:
a third tunneling layer between the first doped conductive layer and the third doped conductive layer, and between the third doped conductive layer and the substrate.

8. The solar cell according to claim 7, wherein a ratio of the first thickness to the second thickness ranges from 1 to 0.2.

9. The solar cell according to claim 7, wherein the first thickness ranges from 70 nm to 180 nm, and the second thickness ranges from 14 nm to 180 nm.

10. The solar cell according to claim 7, wherein an orthographic projection of the first part on the second surface of the substrate at least partially overlaps with an orthographic projection of the third part on the second surface of the substrate.

11. The solar cell according to claim 1, wherein the second thickness gradually increases in a direction from the first protrusion towards the transition region.

12. A manufacturing method for a solar cell, comprising:
providing a substrate including a first surface and a second surface opposing the first surface, where the second surface has a first region and a second region arranged thereon, and a transition region between the first region and the second region, the transition region having a sidewall;
forming a first tunneling layer on the first region;
forming a first doped conductive layer on the first tunneling layer, and forming a first glass layer to cover a surface of the first doped conductive layer, where the first glass layer protrudes from a sidewall of the first doped conductive layer;
forming a second tunneling layer on the second region;
forming a second doped conductive layer on the second tunneling layer;
forming a third doped conductive layer, the third doped conductive layer having a first part on the sidewall of the first doped conductive layer, a second part on the sidewall of the transition region, and a third part extending from an end of the second part in a direction away from the first region toward the second region, wherein the first doped conductive layer has doping ions of a first type, and the third doped conductive layer has doping ions of a second type different form the first type; removing the first glass layer; and
forming a passivation layer over at least surfaces of the first doped conductive layer, the second doped conductive layer, and the third doped conductive layer, where the passivation layer has a first portion over a surface of the first part, and a second portion over a surface of the second part, and wherein the first portion has a first thickness, and the second portion has a second thickness less than the first thickness.

13. The manufacturing method for the solar cell according to claim 12, wherein
forming the third doped conductive layer includes:
forming an initial second doped conductive layer, wherein the initial second doped conductive layer coves the surface of the second tunneling layer, and the initial second doped conductive layer covers a surface of the first glass layer, and the initial second doped conductive layer further covers a surface of the second protrusion and a surface of the recess; and
etching the initial second doped conductive layer to remove the initial second doped conductive layer located on the surface of the first glass layer and partially remove the initial second doped conductive layer located on the surface of the recess, wherein the remaining initial second doped conductive layer located on the second protrusion is used as the second doped conductive layer, and the remaining initial second doped conductive layer located on a sidewall of the recess and a sidewall of the first protrusion is used as the third doped conductive layer.

14. The manufacturing method for the solar cell according to claim 13, wherein
forming the initial second doped conductive layer further includes:
forming a second glass layer to cover a surface of the initial second doped conductive layer, etching the initial second doped conductive layer includes:
performing a laser process, where the laser process irradiates the second glass layer located on the first protrusion and a portion of the second glass layer located on the recess; and
performing an etching process to etch the second glass layer irradiated by the laser process and the initial second doped conductive layer to form the second doped conductive layer and the third doped conductive layer.

15. A photovoltaic module, comprising:
at least one cell string including: a plurality of solar cells according to any one of claims 1 to 14 and solder ribbons electrically connecting adjacent solar cells in series;
an encapsulation film, configured for covering a surface of the at least one cell string; and
a cover plate, configured for covering a surface of the encapsulation film away from the at least one cell string.
